(19) Europäisches Patentamt / European Patent Office / Office européen des brevets

(11) **EP 4 675 484 B1**

(12) **EUROPEAN PATENT SPECIFICATION**

(45) Date of publication and mention
of the grant of the patent:
**20.05.2026 Bulletin 2026/21**

(21) Application number: **24306123.1**

(22) Date of filing: **05.07.2024**

(51) International Patent Classification (IPC):
**G06F 30/15** $^{(2020.01)}$     **G06F 30/17** $^{(2020.01)}$
**G06F 30/23** $^{(2020.01)}$

(52) Cooperative Patent Classification (CPC):
**G06F 30/15; G06F 30/17; G06F 30/23**

(54) **GLOBAL MID-SURFACE JUNCTION SOLVER**

GLOBALER MITTELOBERFLÄCHENVERBINDUNGSLÖSER

RÉSOLVEUR DE JONCTION DE SURFACE MÉDIANE GLOBALE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**07.01.2026 Bulletin 2026/02**

(60) Divisional application:
**26153542.1 / 4 726 598**

(73) Proprietor: **Dassault Systèmes
78140 Vélizy-Villacoublay (FR)**

(72) Inventor: **Chouika, Nabil
78140 Vélizy-Villacoublay (FR)**

(74) Representative: **Bandpay & Greuter
11 rue Christophe Colomb
75008 Paris (FR)**

(56) References cited:
**EP-A1- 3 859 586**

- **REZAYAT M ED - HORMANN KAI ET AL: "Midsurface abstraction from 3D solid models: general theory and applications", COMPUTER-AIDED DESIGN, ELSEVIER PUBLISHERS BV., BARKING, GB, vol. 28, no. 11, 1 November 1996 (1996-11-01), pages 905 - 915, XP004022812, ISSN: 0010-4485, DOI: 10.1016/0010-4485(96) 00018-8**
- **SHEEN D P ET AL: "Transformation of a thin-walled solid model into a surface model via solid deflation", COMPUTER-AIDED DESIGN, ELSEVIER PUBLISHERS BV., BARKING, GB, vol. 42, no. 8, 1 August 2010 (2010-08-01), pages 720 - 730, XP027112300, ISSN: 0010-4485, [retrieved on 20100629]**
- **SHEEN DONG-PYOUNG ET AL: "Dimension Reduction of Solid Models by Mid-Surface Generation", 1 August 2007 (2007-08-01), pages 1 - 10, XP093225250, Retrieved from the Internet <URL:https://koreascience.kr/article/ JAKO200711850422656.pdf> [retrieved on 20241118]**

## Description

## TECHNICAL FIELD

The disclosure relates to the field of computer programs and systems, and more specifically to a method, system and program for B-rep processing for performing structural simulation of a mechanical part.

## BACKGROUND

A number of solutions, hardware and software, are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for analyzing and simulating the physical behavior of a future product. CAM is an acronym for Computer-Aided Manufacturing, e.g. it relates to software solutions for defining product manufacturing processes and resources. CAD solutions, such as the solution provided by Dassault Systèmes under the trademark CATIA, manipulate CAD model representations of mechanical part. Such models may include a feature tree and a boundary representation, also referred to as "B-rep".

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep does not contain any history-based information.

While B-reps represent exactly the shape of a mechanical part to be manufactured, and while manufacturing can directly be performed based on a B-rep representation, after a CAD to CAM conversion, if necessary, as known in the art, engineers may need to perform structural simulations of the mechanical part based on its B-rep representation, before proceeding to manufacturing. A typical example is the simulation of a crash for a B-rep representation of an automotive part. By default, structural simulation of a mechanical part based on its B-rep representation may use a 3D meshing of the B-rep. However, mechanical parts, especially in the automotive industry, may feature (or even consist in) thin solid parts, i.e. solid parts having a thickness smaller than a predefined threshold. For performing structural simulation, these parts may be advantageously replaced by so-called "mid-surfaces". These mid-surfaces may be meshed with 2D mesh elements, while the remaining thick solid parts of the B-rep, if any, are still meshed with 3D mesh elements. The resulting meshing is thus a hybrid mesh, with 3D elements meshing the thick portions of the B-rep, and 2D elements meshing the thin portions of the B-rep, or a 2D meshing only if the B-rep only comprises thin portions. Such a hybrid or 2D mesh is lighter in terms of memory footprint and storage requirement than a 3D mesh of the B-rep. Furthermore, it allows the structural simulation to be performed faster and using fewer computing resources and memory resources. Nevertheless, the simulation is still accurate as replacing a thin part by a corresponding mid-surface is an approximation which is acceptable in terms of accuracy.

Dassault Systèmes currently provides the only solutions that allow to compute a B-rep mid-surface of thin potions of a B-rep volume. For example, the method disclosed in European Patent Application EP20305093.5, filed by Dassault Systèmes, provides such a solution. Other companies produce the discrete surface mesh directly from the thin solid input. Producing an exact mid-surface however first means higher topology quality for the resulting mesh. This directly implies more accurate structural simulation.

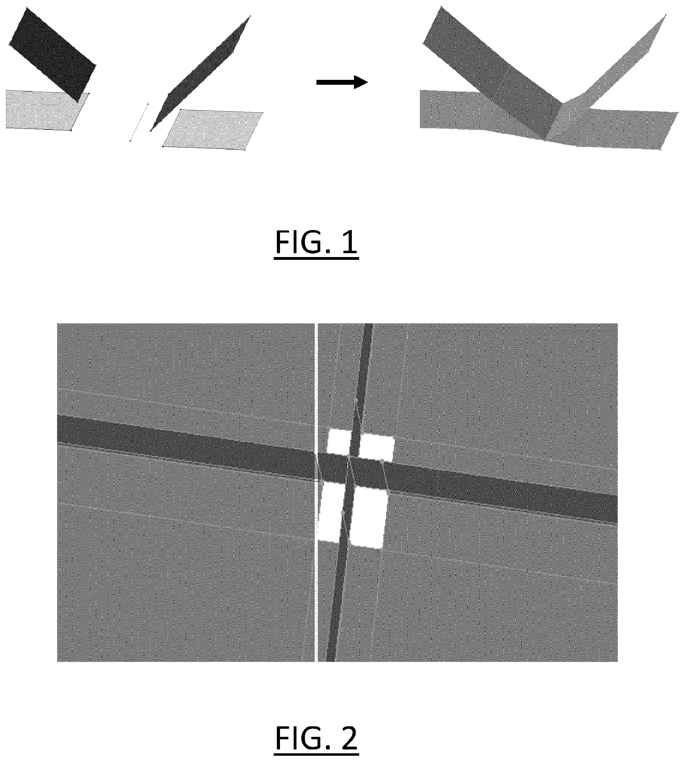

When generating an automatic mid-surface, several minimal skins may be produced that need to be joined together. These minimal skins are therefore involved in junctions. These junctions are solved by filling the matter between the skins and the junction wire as illustrated in FIG. 1, showing an independent junction resolution.

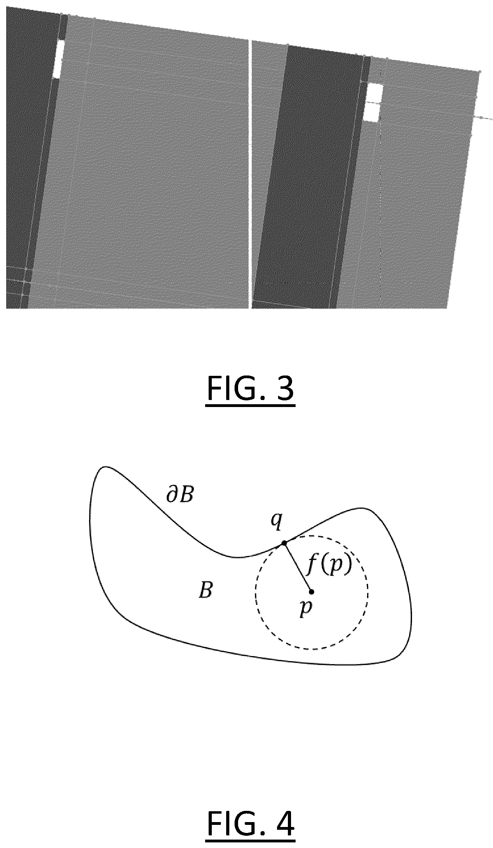

The current software solutions provided by Dassault Systèmes solve junctions independently of each other, which, at least in some cases, may leave missing matter at the multi-junctions (junctions between junctions), as can be seen for instance in FIG. 2, showing a multi-junction to solve with post-processing. These "holes" are then filled in a following step, relying on a detection that is made upstream and based only on the input thin solid. This leads to a lack of genericity and may not work on all models and types of multi junctions. Many robustness issues may be found on industrial models, as can be seen for example in FIG. 3, where holes remain in the mid-surface result. Computation time of the automatic mid-surfacing is also a concern with this hole resolution overhead that could be avoided if junctions are solved with knowledge of each other before hand.

Also known is M. Rezayat, "Midsurface abstraction from 3D solid models: general theory and applications", Computer-Aided Design, Vol. 28, No. 11. pp. 905-915, 1996 Copyrighl ,c , 1996 Elsevier Science ltd, which discloses algorithms for an approach, based on midsurface abstraction, for simplifying simulation driven design.

There is thus a need for an improved solution to solve multi-junctions when replacing thin solid parts of a B-rep by corresponding mid-surfaces.

## SUMMARY

The invention is defined by the appended claims.

## BRIEF DESCRIPTION OF THE DRAWINGS

Non-limiting examples will now be described in reference to the accompanying drawings, where:

- FIG.s 1 to 23 illustrate the method; and

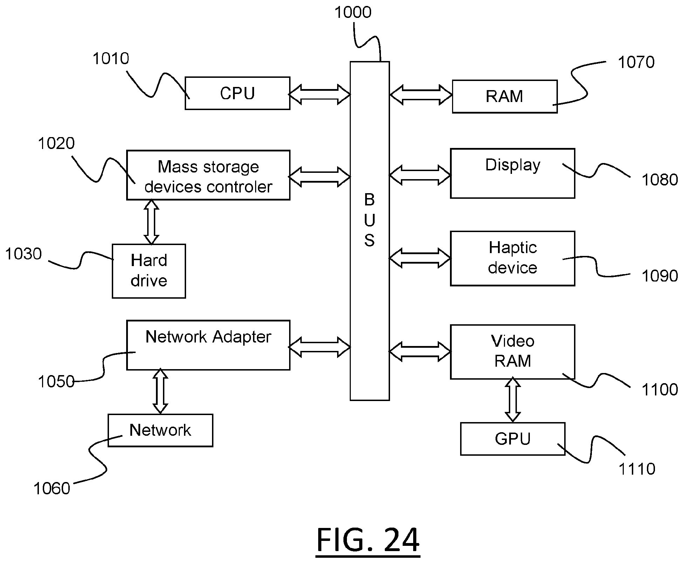

- FIG. 24 shows an example of the system.

## DETAILED DESCRIPTION

It is proposed a computer-implemented method of B-rep processing for performing structural simulation of a mechanical part. The method comprises providing mid-surfaces of a B-rep. The B-rep forming a solid representing the mechanical part. Each mid-surface represents a thin portion of the mechanical part. The method further comprises computing junction wires each corresponding to a respective junction of respective mid-surfaces. The computation of the junction wire is based on border wires of the respective mid-surfaces. The method further comprises determining one or more groups. Each group consists in extremities of junction wires to connect. The determination of the one or more groups is by identifying connected border wires corresponding to the junction wires. The method further comprises, for each determined group of extremities, determining a multi-junction point. The multi-junction point is a connection point of the extremities. The method further comprises connecting the junction wires using the determined multi-junction points. The method further comprises connecting the mid-surfaces to the connected junction wires.

The method constitutes an improved solution for B-rep processing for performing structural simulation of a mechanical part.

Indeed, the method solves the multi-junctions between the mid-surfaces replacing thin solid portions of a B-rep. The method thus allows to replace thin portions of a B-rep by mid-surfaces, for hybrid/2D meshing as discussed above, and obtain a seamless result, without holes. The processed B-rep (i.e. the one with the thin portions replaced by mid-surfaces and all the junctions solved, including the multi-junctions) may thus be meshed in a more accurate manner, which in turn improve the accuracy of the structural simulation. The method may notably further comprise after connection of the mid-surfaces to the connected junction wires, meshing the B-rep, including meshing the mid-surfaces with 2D mesh elements, and optionally performing structural simulation of the mechanical part based on the mesh. Meshing the B-rep may further include, if the B-rep comprises thick solid portions, meshing the thick solid portions with 3D mesh elements. Furthermore, the method provides a solution for solving the multi-junctions which is generic and does not require manual post-processing on a case-by-case basis. The multi-junction computation solution offered by the method can thus be fully automated (i.e. the steps of the method may be completely automated) which provides a generic and flexible solution which applies to all types of configurations. The method notably applies to B-rep models where previous mid-surfacing solutions failed (e.g. resulted in holes), and thus provides a more robust mid-surfacing solution. The method is also efficient, as large and CPU intensive models can be processed in a scalable way.

The simulation may for example be a crash simulation, the mechanical part being for example an automotive part. Because multi-junctions are solved, and the processed B-rep, or its meshing, does not comprise holes, propagation of the collision during crash simulation, and how the part deforms due to this propagation, is more accurately simulated. To be more specific, the holes are completed automatically with a robust and geometrically coherent solution (the claimed method), compared to, for example, manual completion by a user in other mid-surfaces computation solutions, which would be less reliable and dependent on user choices. Accuracy is thus improved. This allows to perform the necessary engineering steps downstream to the simulation to improve safety and/or minimize damages in case of a collision. This results in improved automotive parts, exhibiting improved safety and/or improved resistance to a collision (less deformation for example), since these engineering steps, which are known in the art, are based on more accurate simulation results.

The simulation may alternatively be an air flow simulation, the mechanical part being for example an automotive part or an aerospace part. Because multi-junctions are solved, and the processed B-rep, or its meshing, does not comprise holes, air flow around the part can be more accurately simulated. Again, to be more specific, the holes are completed automatically with a robust and geometrically coherent solution (the claimed method), compared to, for example, manual completion by a user in other mid-surfaces computation solutions, which would be less reliable and dependent on user choices. Accuracy is thus improved. This allows to perform the necessary engineering steps downstream to the simulation to improve aerodynamism of the part. This results in improved parts, exhibiting improved aerodynamics, since these engineering steps, which are known in the art, are based on more accurate simulation results.

The method may be included in a design and/or manufacturing process for designing a CAD model of the part (such model allowing manufacturing) and/or manufacturing the part based in this model. This process may comprise:

- obtaining the B-rep, for example through a previous design process of a CAD feature tree representation of the mechanical part, such feature tree being executable to obtain the B-rep;
- performing the method;
- meshing the processed B-rep resulting from the method with a hybrid 3D-2D mesh or a 2D mesh, where the thin portions replaced by mid-surfaces are meshed with 2D mesh elements, and the thick portions, if any, are meshed with 3D mesh elements;
- performing the structural simulation based on the mesh;
- if necessary, performing engineering steps to modify the B-rep for accounting for the results of the simulation and improve technically the part (for example, to improve aerodynamism or safety as discussed above);
- using the modified B-rep for manufacturing the part, including: storing the B-rep as a CAM file, after a CAD to CAM conversion for converting the B-rep or its corresponding CAD feature tree into a CAM file (such conversion step being known in the art), providing the CAM file to the appropriate machine(s) (*e.g.* 3D printer, machining tools, cutting tools) for manufacturing the part, and/or manufacturing the part using the CAM file (*e.g.* by the machine(s) processing the CAM file).

The method and its features are now further discussed.

The method is for B-rep processing. Specifically, this means that the method takes as input the mid-surfaces of the B-rep, these surfaces representing the thin portions of the mechanical part and connects them to the junction wires that the method obtains (including the solving of the multi-junction points). The method is for performing structural simulation, as the purpose of doing this processing the B-rep is to make it adapted for a computer-efficient structural simulation, as explained above.

The method may optionally comprise, as an initial step, providing the B-rep. Providing the B-rep may comprise designing the B-rep, through a conventional CAD design workflow/process. Alternatively, providing the B-rep may comprise obtaining the B-rep from a (*e.g.* distant) memory or server or database where the B-rep has been stored further to its creation (for example through a design process).

The method comprises providing mid-surfaces of the B-rep. Each mid-surface represents a thin portion of the mechanical part. The definition of a thin portion in the present disclosure is as follows. A thin portion, also referred to as "thin region" or "thin solid portion", is a portion of the B-rep having a thickness smaller than a predefined thickness threshold. Mathematically, this may be defined as follows. Let $B$ be this portion of the B-rep, its boundary $\partial B$ and the function $f$ defined on $p \in B$ as the smallest distance to the boundary $\partial B$ (as illustrated on FIG. 4), *i.e.*

$$f(p) = \min\{\|p - q\|, q \in \partial B\}.$$

Let $K(p)$ be subset of $\partial B$ such that the smallest distance to p is satisfied, *i.e.*

$$K(p) = \{q \in \partial B, \|p - q\| = f(p)\}$$

and let $|K(p)|$ be the number elements of set $K(p)$.

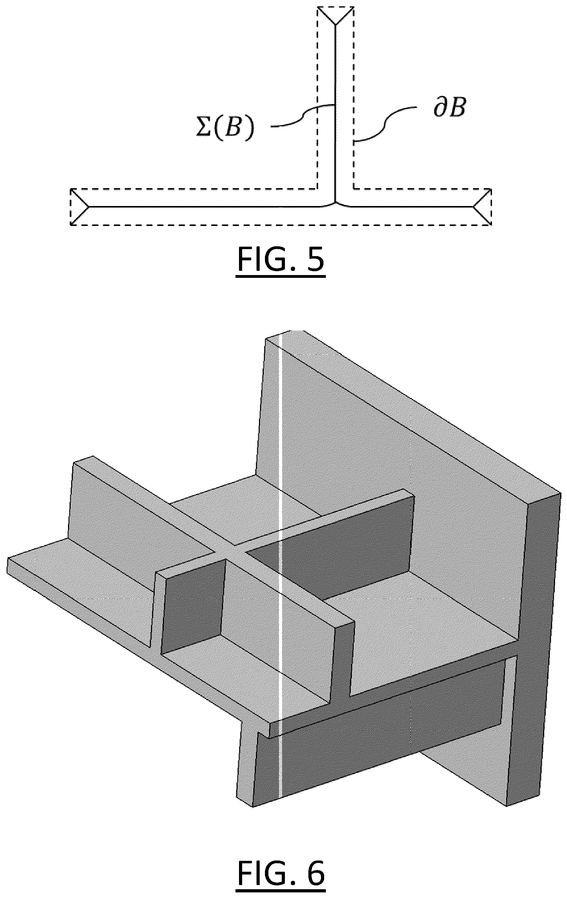

By definition, the medial axis transform of solid B, noted $\Sigma(B)$, is the subset of B (illustrated in the two-dimensional example of FIG. 5) defined such as:

$$\Sigma(B) = \{p \in B, |K(p)| > 1\}.$$

Noting $A(\Sigma(B))$ the area of $\Sigma(B)$:

$$A\big(\Sigma(B)\big) = \int_{\Sigma(B)} d\sigma$$

the average thickness $\bar{t}(B)$ of solid B is defined as:

$$\bar{t}(B) = \frac{2}{A\big(\Sigma(B)\big)} \int_{\Sigma(B)} f \, d\sigma.$$

which corresponds to twice the average value of f over $\Sigma(B)$.

Finally, defining the diameter of solid B as the largest distance separating two points of B:

$$Diam(B) = \max\{\|p - q\|, p \in B, q \in B\}$$

the solid B is a thin solid (or thin portion, or thin region) if the ratio of its average thickness and its diameter is less than the predefined threshold $\varepsilon$:

$$\frac{\bar{t}(X)}{Diam(X)} \lesssim \epsilon.$$

The predefined threshold $\varepsilon$ may be equal to 10%, i.e. $\varepsilon = 0.1$.

The above mathematical definitions can also be found in European Patent Application EP15305809.4.

The concept of "mid-surface" of a thin portion is well known in the field of CAD. The mid-surfaces provided by the method may consist in all the mid-surfaces of all thin portions, i.e. for each thin portion of the mechanical part, or equivalently for each thin solid portion of the B-rep (i.e. that corresponds to a thin portion of the part), the method provides at mid-surface of the thin portion. Providing the mid-surfaces may comprise determining the mid-surfaces by processing the B-rep according to any B-rep processing method configured for computing the mid-surfaces of the thin portion of the B-rep. Alternatively, providing the mid-surfaces may simply comprise retrieving, from a (e.g. distant) memory or server or database, the mid-surfaces already computed by such B-rep processing method. The B-rep processing method for determining the mid-surfaces may be the B-rep processing method disclosed in previously cited European Patent Application EP20305093.5.

FIG. 6 shows an example of a thin solid (i.e. a B-rep with only thin regions). The goal of the B-rep processing method (or operator) that produces (automatically) the mid-surfaces is to produce all the mid-surfaces of all the thin regions of the thin solid. The first step consists of a detection of paired skins from the input volume, based on the estimated thickness. Then, the operator produces minimal mid-surface skins by each offsetting one side of a couple of paired skins, and defines the corresponding junction relations between them, based on the original thin solid. Such minimal skins are surface bodies midway between the corresponding paired skins. As previously discussed, the mid surfaces may be those produced by the B-rep processing method of European Patent Application EP20305093.5. The boundary of each mid-surfaces is formed by edges connected together by vertices. These edges are referred to as "border wires", and these vertices may also be referred to as "the extremities" of the border wires.

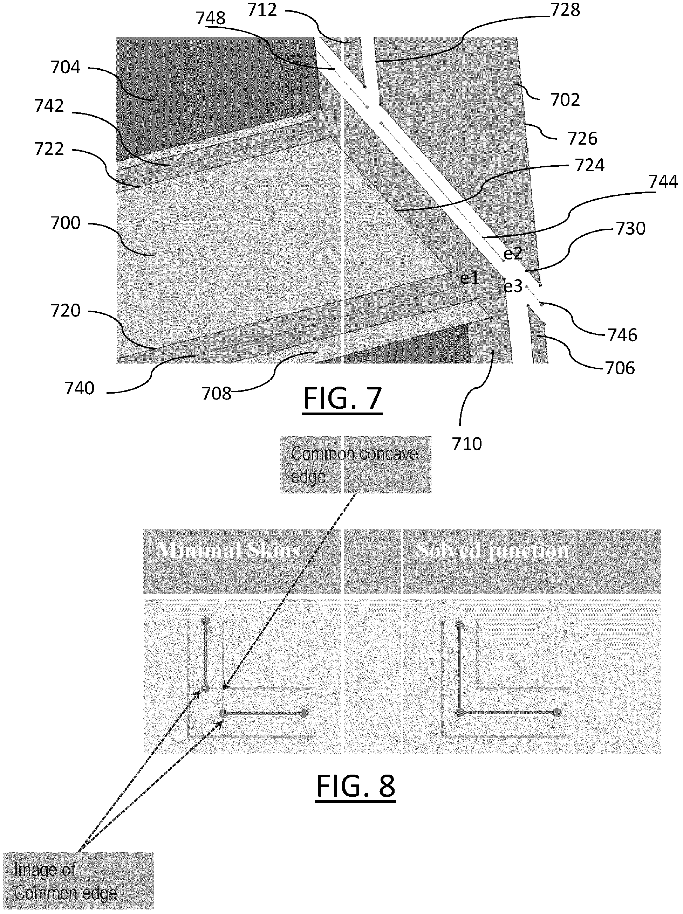

FIG. 7 shows examples of mid-surfaces 700, 702, 704, 706, 708, 710 and 712. Their boundaries are formed by border wires (not all referenced in the figure, for the sake of readability), such as for example border wires 720, 722 and 724 of mid-surface 700, or border wires 726, 728 and 730 of mid-surface 702.

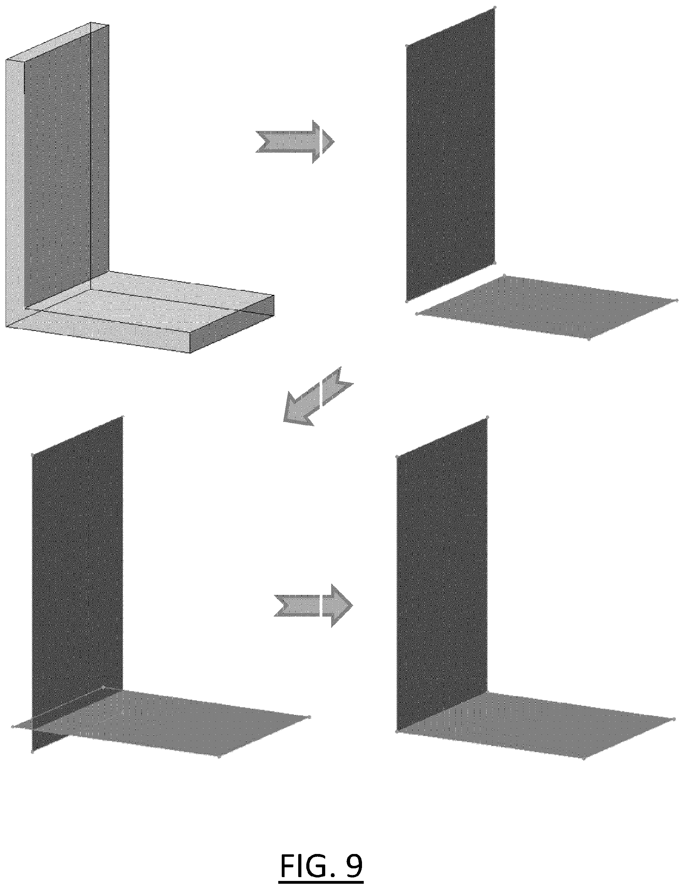

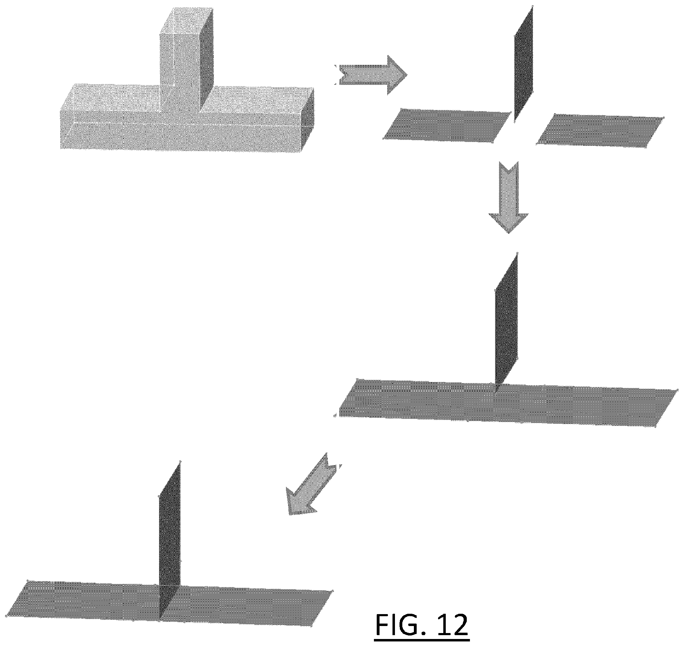

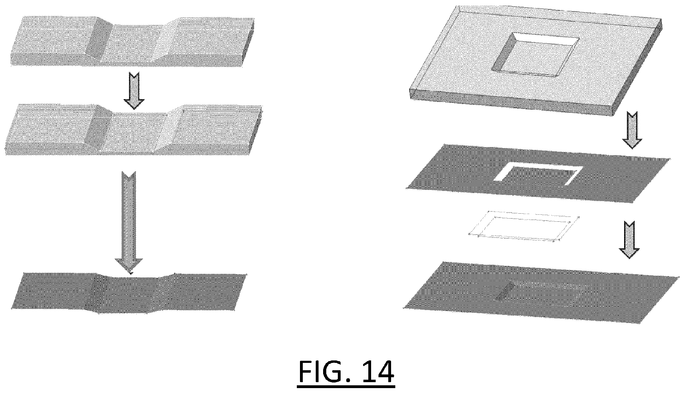

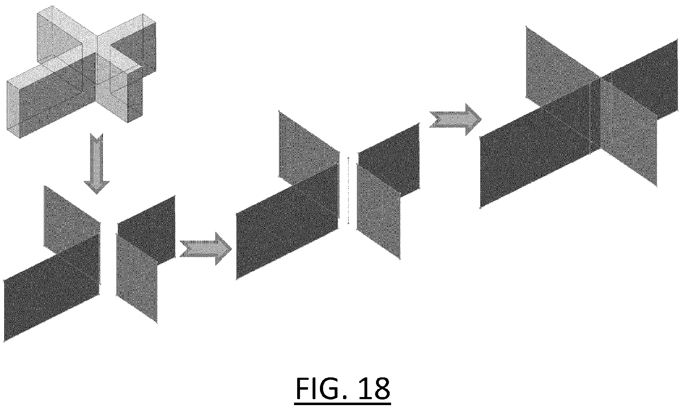

The method further comprises computing junction wires. Each computed junction wire is a junction wire of a respective junction of respective mid-surfaces. The computation of the junction wire is based on the border wires of the respective mid-surfaces. The border wires may be provided as input to the method (i.e. before the step of computing the junction wires), for example by providing the n-uplets of border wires of mid-surfaces involved in junctions (i.e. for which junction wires are computed). The computation of a junction wire of respective mid-surfaces is known in the art. It may for example consists in finding a barycentric wire for all the respective mid-surfaces and may be done for respective mid-surfaces forming a group of surfaces for which finding such barycentric wire is possible, as further discussed hereinafter. Such group represents joining thin solid portions of the B-rep. The junction wire is the theoretical wire where all the respective mid-surfaces would join if the junction was isolated. The computation uses the border wires of the mid-surfaces of the group. FIG.s 9, 11, 13 and 17 illustrate the solving of an isolated junction in the cases of an L junction (FIG. 9), a T junction (FIG. 12), a ramp junction (FIG. 14), and a X junction (FIG. 18).

Computing the junction wire of the respective junction of the respective mid-surfaces may comprise:

a) if the respective mid-surfaces form a L junction, forming the junction wire by extrapolating the respective mid-surfaces until an intersection is reached;

b) if the respective mid-surfaces form a T junction, forming the junction wire by connecting the two respective mid-surfaces of the bottom of the T junction with a blend operation and extrapolating the respective mid-surface of the up of the T junction until reaching an intersection with the result of the blend operation;

c) if the respective mid-surfaces form a ramp junction, forming the junction wire by blending the respective mid-surfaces with a blend operation and offsetting one of the border wires along the result of the blend;

d) if the respective mid-surfaces form a rib junction, forming the junction wire by extrapolating the top respective mid-surface until reaching an intersection with the bottom respective mid-surface,

e) if the respective mid-surfaces form a K junction or any generalization of T junction with an arbitrary number of up mid-surfaces (several up mid-surfaces joining the bottom mid-surface; for a K junction there are 2 such surfaces, and for a T junction 1), forming the junction wire by connecting the two respective mid-surfaces of the bottom of the K junction or T junction generalization with a blend operation and extrapolating the respective up mid-surfaces of the K junction or T junction generalization until reaching an intersection each with the result of the blended bottom skin, and computing the barycenter wire of these intersections if necessary (*i.e.* if the intersections do not form a single wire already); and

f) if the respective mid-surfaces form a junction with is not a rib-junction, a ramp junction, a T junction, a K junction, a T junction generalization or a L junction, forming the junction wire by computing a barycenter wire of the border wires of the respective mid-surfaces.

In other words, the method may compute all the junction wires of the provided mid-surfaces by processing the mid-surfaces according to computations a) to e) above. In other words, the method may perform the following (in any order):

- identifying each group of respective mid-surfaces altogether forming a L-junction, and computing for each group forming the junction wire of the group according to a);
- identifying each group of respective mid-surfaces altogether forming a T-junction, and computing for each group forming the junction wire of the group according to b);
- identifying each group of respective mid-surfaces altogether forming a ramp-junction, and computing for each group forming the junction wire of the group according to c);
- identifying each group of respective mid-surfaces altogether forming a rib-junction, and computing for each group forming the junction wire of the group according to d);
- identifying each group of respective mid-surfaces altogether forming a K junction or T junction generalization, and computing for each group forming the junction wire of the group according to e);
- identifying each group of respective mid-surfaces not forming a rib-junction, a ramp junction, a T junction or a L junction but for which computation f) can be done, and for each group forming the junction wire of group according to f). Groups in this last computational possibility include groups of respective mid-surfaces forming Y junctions or X junctions, for which this barycenter computation is possible.

Upon execution of the above, all possible junction wires of all the provided mid-surfaces are computed.

FIG. 8 illustrates computation a) for mid-surfaces forming a L junction (a plane section is shown). As shown in these figures, forming the junction wire of the mid-surfaces comprises extrapolating the two mid-surfaces starting from the image of the common concave edge of the L-junction (*i.e.* for each mid-surface, the border corresponding to the common concave edge). The resulting junction wire consists of the intersection of the extrapolated mid-surfaces.

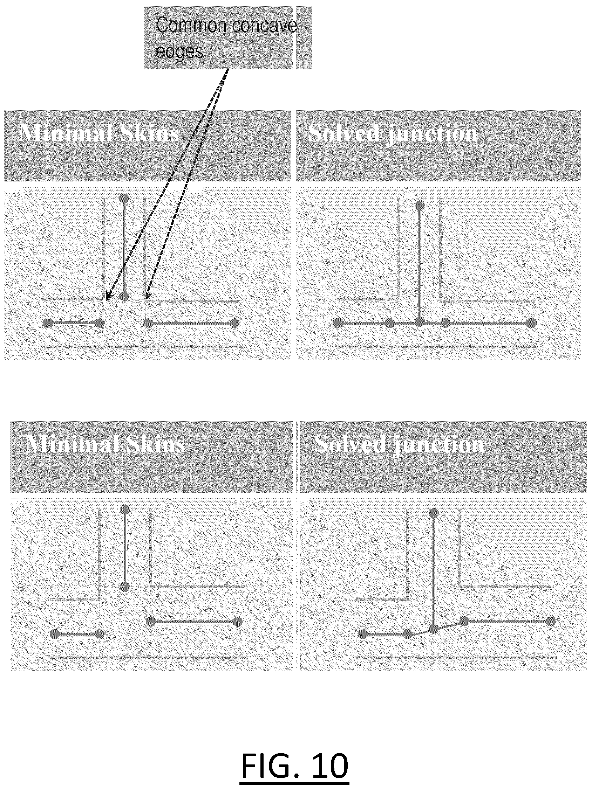

FIG. 10 illustrates computation b) for mid-surfaces forming a T junction (a plane section is shown). As can be seen in the figures, forming the junction wire comprises connecting the two mid-surfaces of the bottom of the T with a blend operation, and then extrapolating the mid-surface of the up of the T and intersecting it with the result of the blend operation.

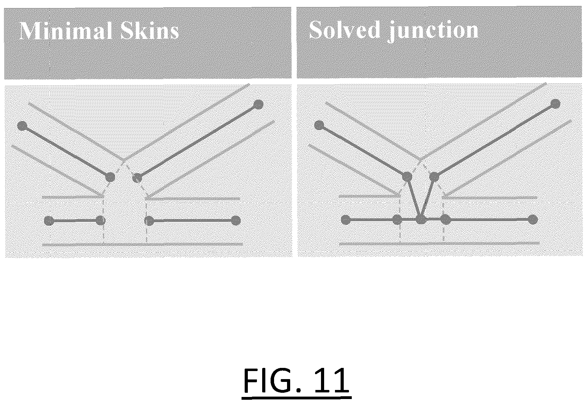

FIG. 11 illustrates computation e) for a K junction.

FIG. 12 illustrates computation c) for mid-surfaces form a ramp junction (a plane section is shown). As can be seen in the figures, forming the junction wire between the two mid-surfaces of the ramp junction comprises connecting the two mid-surfaces of the ramp junction with a blend operation, and offsetting one of the border wires along the result of the blend.

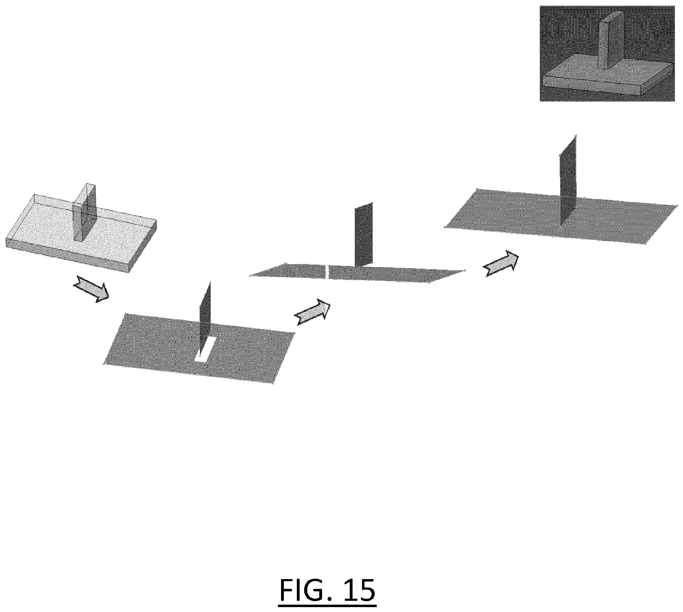

FIG. 15 illustrates computation d) for mid-surfaces forming a rib junction. Forming the junction wire between the two mid-surfaces of the rib comprises filling the necessary matter on the bottom mid-surface of the rib, if applicable, i.e. when the minimal mid-surface skin is the result of the offset of the top paired skin on which the rib is built. Then, forming the junction wire comprises extrapolating the rib mid-surface up to the bottom mid-surface and intersecting them.

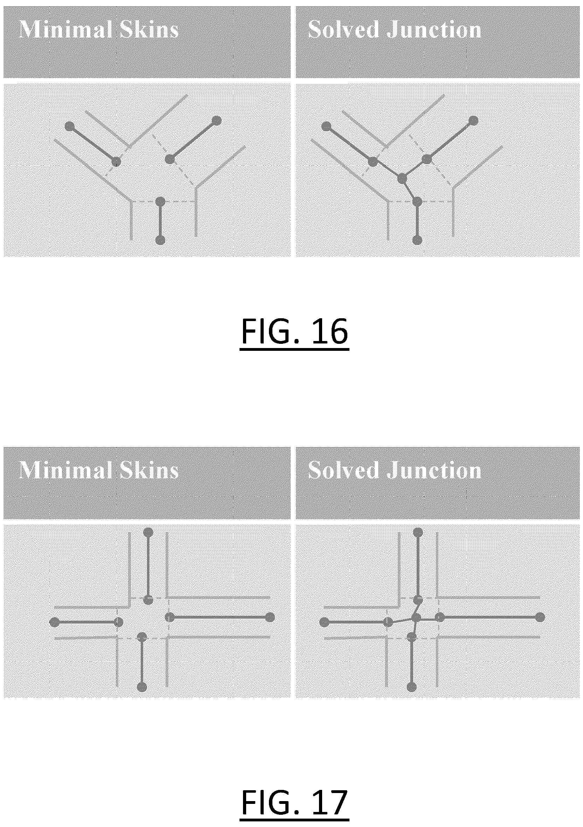

FIG.s 16 and 17 illustrates computation f) for mid-surfaces forming a junction which is not a rib junction, a ramp junction, a T junction or a L junction. The computation consists in finding a barycentric wire of the border wires of the mid-surfaces. FIG. 16 illustrates the case of a Y junction, while FIG. 17 illustrates the case of a X junction.

On the example of FIG. 7, lines 740, 742, 744, 746 and 748 are computed junction wires.

The method further comprises determining one or more groups each of extremities of junction wires to connect. Determining these one or more groups may comprise, for each given extremity of a junction wire, determining, for each extremity of a border wire that corresponds to (*i.e.* that has produced) the given extremity of the junction wire, whether the extremity of the border wire also corresponds to the extremity of another junction wire, and if the extremity of the border wire also corresponds to the extremity of another junction wire, associating the two junction wire extremities. The determination of the groups then comprises grouping together in a same group of extremities which are two-by-two associated (*i.e.* if extremity A is associated with extremity B, and extremity B is associated with extremity C, A, B and C are in a same group). In other words, the method clusters (*e.g.* iteratively) the extremities of the junction wires, each cluster consisting in extremities to be connected because they correspond to connected border wires. This is done by identifying connected border wires corresponding to the junction wires. In other words, the clustering identifies (*e.g.* iteratively) each respective couple of extremities of junction wires which have been obtained from a respective couple of connected border wires (*i.e.* border wires sharing a vertex (or border wire extremity) in their mid-surface) and assigns this respective couple to a same group of extremities. For example, on FIG. 7, extremities e1, e2 and e3 of junction wires 744, 740 and 746 are grouped together and form one of the determined groups.

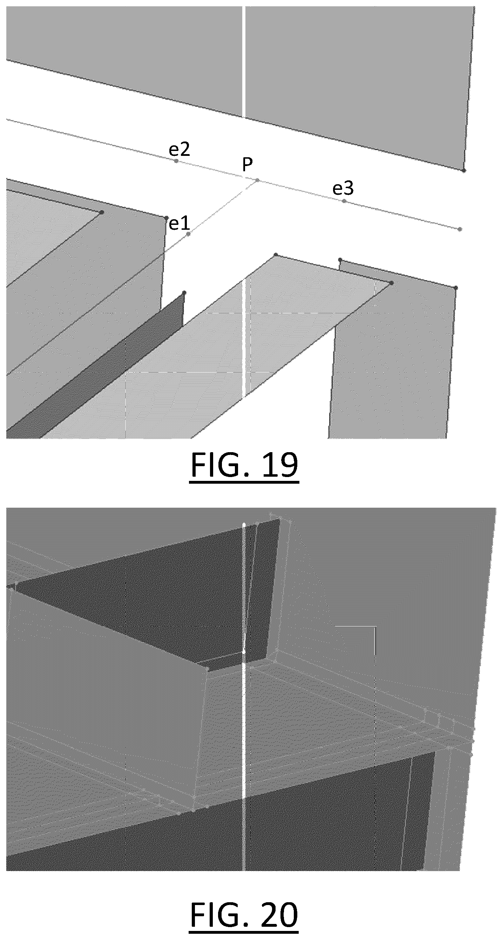

The method further comprises, for each determined group of extremities, determining a multi-junction point. The multi-junction point is a connection point of the extremities (*i.e.* of the group). In other words, this consists in finding a common junction for a group of junction wire extremities, and this for each group, this common junction being the multi-junction point. For each determined group of extremities, determining the multi-junction point may comprise determining the multi-junction point as a medium point of the extremities. For example, the multi-junction point for the group of extremities (e1, e2, e3) of FIG. 7 is the medium point P shown in FIG. 19.

Determining the multi-junction point as a medium point of the extremities may comprise the following steps (which implement a symmetry-preserving algorithm):

- extrapolating each junction wire through its extremity belonging to the group, *i.e.* by applying an extrapolation operator to extrapolate the junction wire, starting from the extremity;
- for each given extrapolated junction wire, determining, on each other extrapolated junction wire (*i.e.* obtained from an extremity belonging to the same group as the extremity from which the given extrapolated junction wire has been obtained), a nearest point (*e.g.* according to the Euclidean distance) to the given extrapolated junction wire and keeping one or more determined points that minimize the accumulated distance to all other determined points (*i.e.*

computing the point, or the points where appropriate, that minimize the (*e.g.* Euclidean) accumulated distance to all other determined points, and keeping these point(s)); and

- determining (*i.e.* for each group of extremities) the medium point as being, among the points kept for each extrapolated junction wire, the point minimizing the (*e.g.* Euclidean) distance to all other kept points or, if there are several points minimizing the distance to all other kept points, as being the barycenter of said several points.

The method further comprises connecting the junction wires using the determined multi-junction points. In other words, the method connects, for each junction wire, each extremity of the junction wire for which a respective multi-junction point has been determined to this junction point. Connecting the junction wires using the determined multi-junction points may comprise, for each determined group of extremities, connecting each extremity, with a respective line segment, to the multi-junction point determined for this group of extremities. FIG. 19 illustrates the result of this connection, extremities e1, e2 and e3 being connected to P.

It is to be understood that the junction wires that result from this step of connection of the junction wires may not necessarily form a single connected junction wire. To be specific, where there is a multi-junction point, each junction wire for which the multi-junction point has been determined is connected to this multi-junction point. This does however not exclude this connection to be disconnected from other connections corresponding to other multi-junction points, nor that there may be one or more junction wires which are not connected to any multi-junction point (they may be referred to as "isolated wires").

The method further comprises connecting the mid-surfaces to the connected (if multi junctions are involved) or isolated junction wires. Thereby, the method connects all the mid-surfaces together without holes at the multi-junctions. Connecting the mid-surfaces to the connected junction wires may comprise connecting the mid-surfaces using a blend operation between the connected or isolated junction wires and their corresponding border wires. FIG. 20 shows the result of this connection for the set of mid-surfaces shown in FIG. 7.

Further to this last step of connection of the mid-surfaces to the connected junction wires, the B-rep is processed: the thin regions are replaced by their mid-surfaces, and these mid-surfaces are connected, without holes. The method may output this processed B-rep, for structural simulation.

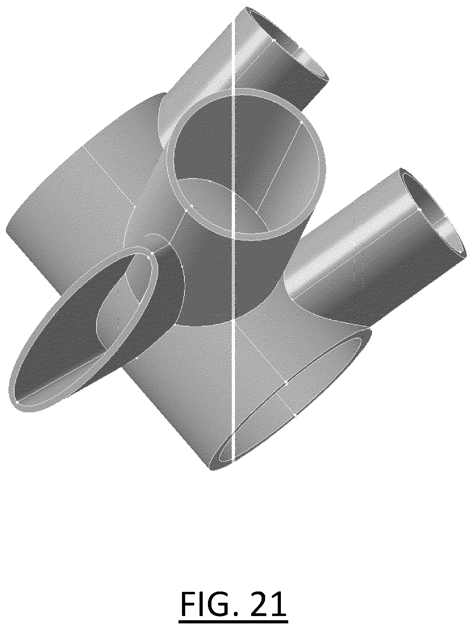

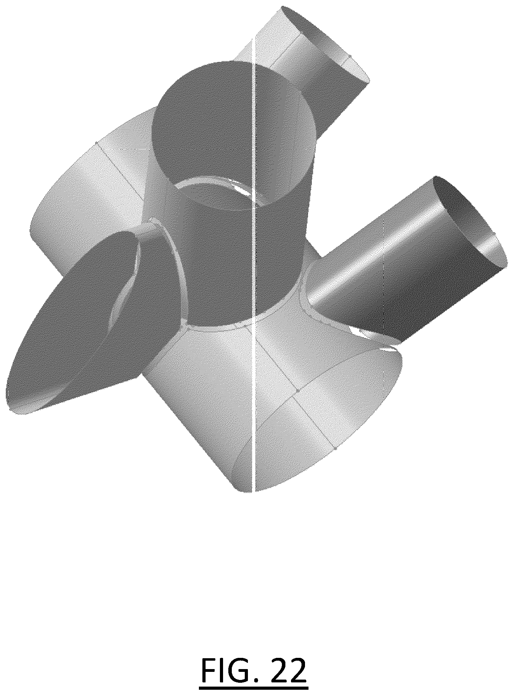

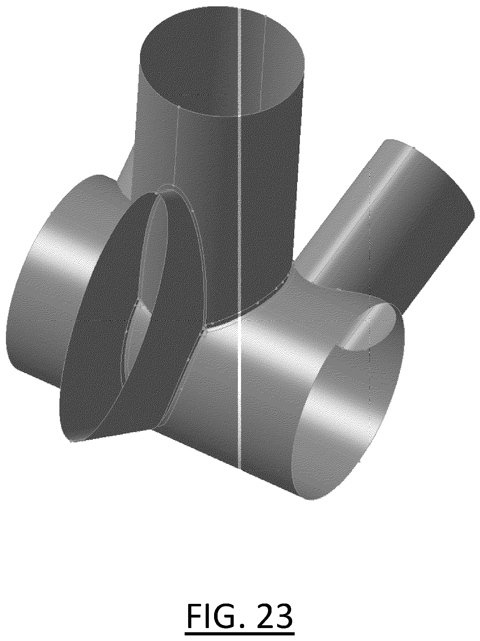

FIG.s 21 to 23 illustrate a result obtained with the method. FIG. 21 shows an example of the B-rep, FIG. 22 the mid-surfaces thereof, and FIG. 23 the connected mid-surfaces with all the junctions solved.

"Designing a manufacturing product/mechanical part/mechanical product" designates any action or series of actions which is at least a part of a process of elaborating a modeled object (3D or 2D) of the manufacturing product/mechanical part/mechanical product. The method may form such a process or may form at least a part of the process as explained above.

The method thus generally manipulates modeled objects, such as the B-rep model representing the mechanical part. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD, CAE, PLM and/or CAM system, as will be apparent from the definitions of such systems provided below.

By CAD solution (e.g. a CAD system or a CAD software), it is additionally meant any system, software or hardware, adapted at least for designing a modeled object on the basis of a graphical representation of the modeled object and/or on a structured representation thereof (e.g. a feature tree), such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 2D or 3D modeled object, e.g. representing a product such as a part or an assembly of parts, or possibly an assembly of products. The 2D or 3D modeled object may be a manufacturing product, i.e. a product to be manufactured. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The modeled object may represent the geometry of a product to be manufactured in the real world subsequent to the completion of its virtual design with for instance a CAD/CAE software solution or CAD/CAE system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD/CAE software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolve, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAE solution, it is additionally meant any solution, software of hardware, adapted for the analysis of the physical behavior of a modeled object. A well-known and widely used CAE technique is the Finite Element Model (FEM) which is equivalently referred to as CAE model hereinafter. An FEM typically involves a division of a modeled object into elements, i.e., a finite element mesh, which physical behaviors can be computed and simulated through equations. Such CAE solutions are provided by Dassault Systèmes under the trademark SIMULIA®. Another growing CAE technique involves the modeling and analysis of complex systems composed a plurality of components from different fields of physics without CAD geometry data. CAE solutions allow the simulation and thus the optimization, the improvement and the validation of products to manufacture. Such CAE solutions are provided by Dassault Systèmes under the trademark DYMOLA®. CAE may be used to ensure that various structural requirements (such as, but not limited to, mass, stiffness, strength, durability) are achieved by a new CAD model. Some of these requirements may be called Key Performance Indicators (KPIs). For many industrial products (for example cars, airplanes, consumer packaged goods, hi-tech), these KPIs are in conflict e.g. lower mass usually causes lower stiffness. Thus, optimization methods are often applied to find the best trade-off between the KPIs.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided extrusion feature in a CAD model. Such CAM solutions are provided by Dassault Systèmes under the trademarks CATIA, Solidworks or trademark DELMIA®.

CAD and CAM solutions are therefore tightly related. Indeed, a CAD solution focuses on the design of a product or part and CAM solution focuses on how to make it. Designing a CAD model is a first step towards a computer-aided manufacturing. Indeed, CAD solutions provide key functionalities, such as feature based modeling and boundary representation (B-Rep), to reduce the risk of errors and the loss of precision during the manufacturing process handled with a CAM solution. Indeed, a CAD model is intended to be manufactured. Therefore, it is a virtual twin, also called digital twin, of an object to be manufactured with two objectives:

- checking the correct behavior of the object to be manufactured in a specific environment; and
- ensuring the manufacturability of the object to be manufactured.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, sales people and buyers. A PDM solution is generally based on a product-oriented database. It allows the actors to share consistent data on their products and therefore prevents actors from using divergent data. Such PDM solutions are provided by Dassault Systèmes under the trademark ENOVIA®.

The modeled object processed by the method is a CAD model which is a B-rep, and may optionally also comprise the feature tree from which the B-rep stems. Such a model may stem from a CAE model and may results from a CAE to CAD conversion process, that the method may for example comprise at an initial stage.

The CAD model may be feature-based (e.g. it may comprise a feature tree, and optionally a corresponding B-rep obtained by executing the feature tree). A feature-based 3D model allows (e.g. during the determination of a manufacturing file or CAM file as discussed hereinafter) the detection and an automatic resolution of a geometry error in a CAD model such as a clash that will affect the manufacturing process. A clash is an interpenetration between two parts of a 3D model for example due to their relative motion. Furthermore, this clash may sometimes only be detected via a finite element analysis based on the CAD feature-based model. Therefore, a resolution of a clash can be performed with or automatically by the CAD solution by iteratively modifying the parameters of the features and doing a finite element analysis.

As another example, a feature-based 3D model allows (e.g. during the determination of a manufacturing file or CAM file as discussed hereinafter) an automatic creation of a toolpath for a machine via a computer numerical control (CNC). With CNC, each object to be manufactured gets a custom computer program, stored in and executed by the machine control unit, a microcomputer attached to the machine. The program contains the instructions and parameters the machine tool will follow. Mills, lathes, routers, grinders and lasers are examples of common machine tools whose operations can be automated with CNC.

A key characteristic of a CAD model is that it may be designed exactly and unambiguously by chaining a small number of high-level parameterized design operations (including for example, but not limited to, sketch, extrusion, chamfer) and edited by modifying its high-level parameters. That this is a key distinction with the polyhedral representations such as a triangular surface mesh which may represent any 3D shape but do not provide modification or parameterization capabilities required in an industrial design context.

As CAD model is a parameterized model of a part/product, it is lighter in terms of memory footprint than other models such as a CAE model. Indeed, instead of storing a collection of discrete geometrical elements such as finite elements, a CAD model allows the storing of a list of features and parameters, which is lighter in terms of storage and memory footprint. Working on CAD models thus reduced memory requirements for the underlying systems, as compared for example to CAE models, in addition to facilitate editability of the model. This amounts to say that a CAE to CAD conversion process in fact compresses the CAE model into a CAD model which is lighter in terms of memory requirements (e.g. footprint), in addition to transforming the CAE model into a more easily editable CAD model.

The generation of a custom computer program from CAD files may be automated. Such generation may therefore be errorproof and may ensure a perfect reproduction of the CAD model to a manufactured product. CNC is considered to provide more precision, complexity and repeatability than is possible with manual machining. Other benefits include greater accuracy, speed and flexibility, as well as capabilities such as contour machining, which allows milling of contoured shapes, including those produced in 3D designs.

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep doesn't contain any history-based information.

The method may be included in a production process, which may comprise, after performing the method, producing a physical product corresponding to the modeled object designed/processed/outputted by the method. The production process may comprise the following steps:

- (e.g. automatically) applying the method, thereby obtaining the CAD model outputted by the method;
- using the obtained CAD model for manufacturing the part/product.

Using a CAD model for manufacturing designates any real-world action or series of action that is/are involved in/participate to the manufacturing of the product/part represented by the CAD model. Using the CAD model for manufacturing may for example comprise one or more of the following steps:

- editing the obtained CAD model;
- performing simulation(s) based on the CAD model or on a corresponding CAE model (*e.g.* the CAE model from which the CAD model stems, after a CAE to CAD conversion process), such as simulations for validation of mechanical, use and/or manufacturing properties and/or constraints (*e.g.* structural simulations, thermodynamics simulation, aerodynamic simulations);
- editing the CAD model based on the results of the simulation(s);
- optionally (*i.e.* depending on the manufacturing process used, the production of the mechanical product may or may not comprise this step), (*e.g.* automatically) determining a manufacturing file/CAM file (*e.g.* comprising manufacturing instructions for manufacturing the product represented by the CAD model and/or control instructions for the manufacturing process and/or for commanding the manufacturing process or manufacturing tool(s) thereof) based on the (*e.g.* edited) CAD model (e.g. the control instructions stem from the CAD file storing the CAD model and/or specifications of the CAD model), for production/manufacturing of the manufacturing product;
- sending the CAD file and/or the manufacturing file/-CAM file to a factory in view of manufacturing the product represented by the CAD model; and/or
- (*e.g.* automatically) producing/manufacturing, based on the determined manufacturing file/CAM file or on the CAD model, the mechanical product originally represented by the model outputted by the method. This may include feeding (*e.g.* automatically) the manufacturing file/CAM file and/or the CAD file to the machine(s) performing the manufacturing process.

This last step of production/manufacturing may be referred to as the manufacturing step or production step. This step manufactures/fabricates the part/product based on the CAD model and/or the CAM file, *e.g.* upon the CAD model and/or CAD file being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps. Because the design method improves the design of a model (CAE or CAD) representing the part/product, the manufacturing and its productivity are also improved.

Editing the CAD model may comprise, by a user (*i.e.* a designer), performing one or more editions of the CAD model, e.g. by using a CAD solution. The modifications of the CAD model may include one or more modifications each of a geometry and/or of a parameter of the CAD model. The modifications may include any modification or series of modifications performed on a feature tree of the model (*e.g.* modification of feature parameters and/or specifications) and/or modifications performed on a displayed representation of the CAD model (*e.g.* a B-rep). The modifications are modifications which maintain the technical functionalities of the part/product, i.e. the user performs modifications which may affect the geometry and/or parameters of the model but only with the purpose of making the CAD model technically more compliant with the downstream use and/or manufacturing of the part/product. Such modifications may include any modification or series of modification that make the CAD model technically compliant with specifications of the machine(s) used in the downstream manufacturing process. Such modifications may additionally or alternatively include any modification or series of modification that make the CAD model technically compliant with a further use of the product/part once manufactured, such modification or series of modifications being for example based on results of the simulation(s).

The CAM file may comprise a manufacturing set up model obtained from the CAD model. The manufacturing set up may comprise all data required for manufacturing the mechanical product (*e.g.* control instructions for controlling the manufacturing process) so that it has a geometry and/or a distribution of material that corresponds to what is captured by the CAD model, possibly up to manufacturing tolerance errors. Determining the production file may comprise applying any CAM (Computer-Aided Manufacturing) or CAD-to-CAM solution for (*e.g.* automatically) determining a production file from the CAD model (*e.g.* any automated CAD-to-CAM conversion algorithm). Such CAM or CAD-to-CAM solutions may include one or more of the following software solutions, which enable automatic generation of manufacturing instructions and tool paths for a given manufacturing process based on a CAD model of the product to manufacture:

- Fusion 360,
- FreeCAD,
- CATIA,
- SOLIDWORKS,
- The NC Shop Floor programmer of Dassault Systèmes illustrated on https://my.3dexperience.3ds. com/welcome/fr/compass-world/rootroles/nc-shop-floor-programmer,
- The NC Mill-Turn Machine Programmer of Dassault Systèmes illustrated on https://my.3dexperien ce.3ds.com/welcome/fr/compass-world/rootroles/ nc-mill-turn-machine-programmer, and/or
- The Powder Bed Machine Programmer of Dassault Systèmes illustrated on https://my.3dexperien ce.3ds.com/welcome/fr/compass-world/rootroles/ powder-bed-machine-programmer.

The product/part may be an additive manufacturable part, *i.e.* a part to be manufactured by additive manufacturing (*i.e.* 3D printing). In this case, the production process does not comprise the step of determining the CAM file and directly proceeds to the producing/manufacturing step, by directly (*e.g.* and automatically) feeding a 3D printer with the CAD model. 3D printers are configured for, upon being fed with a CAD model representing a mechanical product (*e.g.* and upon launching, by a 3D printer operator, the 3D printing), directly and automatically 3D print the mechanical product in accordance with the CAD model. In other words, the 3D printer receive the CAD model, which is (*e.g.* automatically) fed to it, reads (*e.g.* automatically) the CAD model, and prints (*e.g.* automatically) the part by adding together material, *e.g.* layer by layer, to reproduce the geometry and/or distribution of material captured by the CAD model. The 3D printer adds the material to thereby reproduce exactly in reality the geometry and/or distribution of material captured by the CAD model, up to the resolution of the 3D printer, and optionally with or without tolerance errors and/or manufacturing corrections. The manufacturing may comprise, *e.g.* by a user (*e.g.* an operator of the 3D printer) or automatically (by the 3D printer or a computer system controlling it), determining such manufacturing corrections and/or tolerance errors, for example by modifying the CAD file to match specifications of the 3D printer. The production process may additionally or alternatively comprise determining (*e.g.* automatically by the 3D printer or a computer system controlling it) from the CAD model, a printing direction, for example to minimize overhang volume (as described in European patent No. 3327593), a layer-slicing (i.e., determining thickness of each layer, and layer-wise paths/trajectories and other characteristics for the 3D printer head (e.g., for a laser beam, for example the path, speed, intensity/temperature, and other parameters).

The product/part may alternatively be a machined part (*i.e.* a part manufactured by machining), such as a milled part (*i.e.* a part manufactured by milling). In such a case, the production process may comprise a step of determining the CAM file. This step may be carried out automatically, by any suitable CAM solution to automatically obtain a CAM file from a CAD model of a machined part. The determination of the CAM file may comprise (*e.g.* automatically) checking if the CAD model has any geometric particularity (*e.g.* error or artefact) that may affect the production process and (*e.g.* automatically) correcting such particularities. For example, machining or milling based on the CAD model may not be carried out if the CAD model still comprises sharp edges (because the machining or milling tool cannot create sharp edges), and in such a case the determination of the CAM file may comprise (*e.g.* automatically) rounding or filleting such sharp edges (*e.g.* with a round or fillet radius that corresponds, e.g. substantially equals up to a tolerance error, the radius of the cutting head of the machining tool), so that machining or milling based on the CAD model can be done. More generally, the determination of the CAM file may automatically comprise rounding or filleting geometries within the CAD model that are incompatible with the radius of the machining or milling tool, to enable machining/milling. This check and possible corrections (*e.g.* rounding or filleting of geometries) may be carried out automatically as previously discussed, but also, by a user (*e.g.* a machining engineer), which performs the correction by hand on a CAD and/or CAM solution, *e.g.* the solution constraining the user to perform corrections that make the CAD model compliant with specifications of the tool used in the machining process.

Further to the check, the determination of the CAM file may comprise (e.g. automatically) determining the machining or milling path, i.e. the path to be taken by the machining tool to machine the product. The path may comprise a set of coordinates and/or a parameterized trajectory to be followed by the machining tool for machining, and determining the path may comprise (*e.g.* automatically) computing these coordinates and/or trajectory based on the CAD model. This computation may be based on the computation of a boundary of a Minkowski subtraction of the CAD model by a CAD model representation of the machining tool, as for example discussed in European Patent Application EP21306754.9 filed on 13 December 2021 by Dassault Systèmes. It is to be understood that the path may be a single path, *e.g.* that the tool continuously follows without breaking contact with the material to be cut. Alternatively, the path may be a concatenation of a sequence sub-paths to be followed in a certain order by the tool, *e.g.* each being continuously followed by the tool without breaking contact with the material to be cut. Optionally, the determination of the CAM file may then comprise (*e.g.* automatically) setting machine parameters, including cutting speed, cut/pierce height, and/or mold opening stroke, for example based on the determined path and on the specification of the machine. Optionally, the determination of the CAM file may then comprise (*e.g.* automatically) configuring nesting where the CAM solution decides the best orientation for a part to maximize machining efficiency.

In this case of a machining or milling part, the determining of the CAM file thus results in, and outputs, the CAM file comprising a machining path, and optionally the set machine parameters and/or specifications of the configured nesting. This outputted CAM file may be then (*e.g.* directly and automatically) fed to the machining tool and/or the machining tool may then (*e.g.* directly and automatically) be programmed by reading the file, upon which the production process comprises the producing/-manufacturing step where the machine performs the machining of the product according to the production file, *e.g.* by directly and automatically executing the production file. The machining process comprises the machining tool cutting a real-world block of material to reproduce the geometry and/or distribution of material captured by the CAD model, *e.g.* up to a tolerance error (*e.g.* tens of microns for milling).

The product/part may alternatively be a molded part, *i.e.* a part manufactured by molding (*e.g.* injection-molding). In such a case, the production process may comprise the step of determining the CAM file. This step may be carried out automatically, by any suitable CAM solution to automatically obtain a CAM file from a CAD model of a molded part. The determining of the CAM file may comprise (*e.g.* automatically) performing a sequence of molding checks based on the CAD model to check that the geometry and/or distribution of material captured by the CAD model is adapted for molding, and (*e.g.* automatically) performing the appropriate corrections if the CAD model is not adapted for molding. Performing the checks and the appropriate corrections (if any) may be carried out automatically, or, alternatively, by a user (*e.g.* a molding engineer), for example using a CAD and/or CAM solution that allows a user to perform the appropriate corrections on the CAD model but constraints him/her corrections that make the CAD model compliant with specifications of the molding tool(s). The checks may include: verifying that the virtual product as represented by the CAD model is consistent with the dimensions of the mold and/or verifying that the CAD model comprises all the draft angles required for demolding the product, as known *per se* from molding. The determining of the CAM file may then further comprise determining, based on the CAD model, a quantity of liquid material to be used for molding, and/or a time to let the liquid material harden/set inside the mold, and outputting a CAM file comprising these parameters. The production process then comprises (*e.g.* automatically) performing the molding based on the outputted file, where the mold shapes, for the determined hardening time, a liquid material into a shape that corresponds to the geometry and/or distribution of material captured by the CAD model, *e.g.* up to a tolerance error (*e.g.* up to the incorporation of draft angles or to the modification of draft angles, for demolding).

The product/part may alternatively be a stamped part, also possibly referred to as "stamping part", *i.e.* a part to be manufactured in a stamping process. The production process may in this case comprise (*e.g.* automatically) determining a CAM file based on the CAD model. The CAD model represents the stamping part, e.g. possible with one or more flanges if the part is to comprise some, and possibly in this latter case with extra material to be removed so as to form an unfolded state of one or more flanges of the part, as known *per se* from stamping. The CAD model thus comprises a portion that represents the part without the flanges (which is the whole part in some cases) and possibly an outer extra patch portion that represents the flanges (if any), with possibly the extra material (if any). This extra patch portion may present a g2-continuity over a certain length and then a g1-continuity over a certain length.

The determination of the CAM file may in this stamping case comprise (*e.g.* automatically) determining parameters of the stamping machine, for example a size of a stamping die or punch and/or a stamping force, based on the geometry and/or distribution of material of the virtual product as captured by the CAD model. If the CAD model also comprises the representation of the extra material to be removed so as to form an unfolded state of one or more flanges of the part, the extra material to be removed may for example be cut by machining, and determining the CAM file may also comprise determining a corresponding machining CAM file, *e.g.* as discussed previously. If there are one or more flanges, determining the CAM file may comprise determining geometrical specifications of the g2-continuity and g1-continuity portions that allow, after the stamping itself and the removal of the extra material, to fold in a folding process the flanges towards an inner surface of the stamped part and along the g2-continuity length. The CAM file thereby determined may thus comprise: parameters of the stamping tool, optionally said specifications for folding the flanges (if any), and optionally a machining production file for removing the extra material (if any).

The stamping production process may then output, *e.g.* directly and automatically, the CAM file, and perform the stamping process (*e.g.* automatically) based on the file. The stamping process may comprise stamping (*e.g.* punching) a portion of material to form the product as represented by the CAD file, that is possibly with the unfolded flanges and the extra material (if any). Where appropriate, the stamping process may then comprise cutting the extra material based on the machining production file and folding the flanges based on said specifications for folding the flanges, thereby folding the flanges on their g2-continuity length and giving a smooth aspect to the outer boundary of the part. In this latter case, the shape of the part once manufactured differ from its virtual counterpart as represented by the CAD model in that the extra material is removed and the flanges are folded, whereas the CAD model represents the part with the extra material and the flanges in an unfolded state.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 24 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

**Claims**

1. A computer-implemented method of B-rep processing for performing structural simulation of a mechanical part:

    - providing mid-surfaces (700, 702, 704, 706, 708, 710, 712) of a B-rep forming a solid representing the mechanical part, each mid-surface representing a thin portion of the mechanical part;
    - computing junction wires (740, 742, 744, 746, 748) each corresponding to a respective junction of respective mid-surfaces based on border wires (720, 722, 724) of the respective mid-surfaces;
    - determining one or more groups (e1, e2, e3) each of extremities of junction wires to connect (740, 744, 746) by identifying connected border wires corresponding to the junction wires;

- for each determined group (e1, e2, e3) of extremities, determining a multi-junction point (P) which is a connection point of the extremities;
- connecting the junction wires using the determined multi-junction points; and
- connecting the mid-surfaces to the connected junction wires,

wherein, for each determined group (e1, e2, e3) of extremities, determining the multi-junction point (P) comprises determining the multi-junction point (P) as a medium point of the extremities (e1, e2, e3),

wherein the method further comprises performing a simulation based on the B-rep,

wherein in the simulation the connected mid-surfaces are meshed with 2D elements, and the thick solid parts of the B-rep are meshed with 3D elements, where:

- the B-rep represents an automotive part and the simulation is a crash simulation to simulate propagation of a collision and deformation of the part as a result of the crash; or
- the B-rep represents an automotive part or an aerospace part and the simulation is an airflow simulation;

wherein the method further comprises:

- if the simulation is a crash simulation, using the results of the simulation to modify the B-rep to reduce deformation of the automotive part in the case of a crash; or
- if the simulation is an airflow simulation, using the results of the simulation to modify the B-rep to improve aerodynamism of the automotive or aerospace part;

and wherein the method further comprises using the modified B-rep for manufacturing the improved part.

2. The method of claim 1, wherein determining the multi-junction point (P) as a medium point of the extremities (e1, e2, e3) comprises:

- extrapolating each junction wire through its extremity belonging to the group;
- for each given extrapolated junction wire, determining, on each other extrapolated junction wire, a nearest point to the given extrapolated junction wire and keeping one or more determined points that minimize a distance to all other determined points; and
- determining the medium point as being, among the points kept for each extrapolated junction wire, the point minimizing a distance to all other kept points or, if there are several points minimizing the distance to all other kept points, the barycenter of said several points.

3. The method of any one of claims 1 to 2, wherein connecting the junction wires using the determined multi-junction points comprises, for each determined group of extremities, connecting each extremity, with a respective line segment, to the multi-junction point determined for this group of extremities.

4. The method of any one of claims 1 to 3, wherein connecting the mid-surfaces to the connected junction wires comprises connecting the mid-surfaces using a blend operation between the connected junction wires and their corresponding border wires.

5. The method of any one of claims 1 to 4, wherein determining the one or more groups (e1, e2, e3) each of extremities of junction wires to connect (740, 744, 746) by identifying connected border wires corresponding to the junction wires comprises:

- for each given extremity of a junction wire, determining, for each extremity of a border wire that corresponds to the given extremity of the junction wire, whether the extremity of the border wire also corresponds to the extremity of another junction wire, and if the extremity of the border wire also corresponds to the extremity of another junction wire, associating the two junction wire extremities; and
- grouping, together in a same group, extremities which are two-by-two associated.

6. The method of any one of claims 1 to 5, wherein computing the junction wire of the respective junction of the respective mid-surfaces comprises:

- if the respective mid-surfaces form a L junction, forming the junction wire by extrapolating the respective mid-surfaces until an intersection is reached;
- if the respective mid-surfaces form a T junction, forming the junction wire by connecting the two respective mid-surfaces of the bottom of the T junction with a blend operation and extrapolating the respective mid-surface of the up of the T junction until reaching an intersection with the result of the blend operation;
- if the respective mid-surfaces form a ramp junction, forming the junction wire by blending the respective mid-surfaces with a blend operation and offsetting one of the border wires along the result of the blend;
- if the respective mid-surfaces form a rib junction, forming the junction wire by extrapolating the top respective mid-surface until reaching an intersection with the bottom respective mid-surface;

- if the respective mid-surfaces form a K junction or any generalization of a T junction with an arbitrary number of up mid-surfaces, forming the junction wire by connecting the two respective mid-surfaces of the bottom of the K junction or T junction generalization with a blend operation and extrapolating the respective up mid-surfaces of the K junction or T junction generalization until reaching an intersection each with the result of the blended bottom skin, and computing the barycenter wire of these intersections if necessary; and

- if the respective mid-surfaces form a junction with is not a rib-junction, a ramp junction, a T junction, a K junction, a T junction generalization or a L junction, forming the junction wire by computing a barycenter wire of the border wires of the respective mid-surfaces.

7. A computer program comprising instructions which, when executed by a computer system, cause the computer system to perform the method of any one of claims 1 to 6.

8. A computer-readable data storage medium having recorded thereon the computer program of claim 7.

9. A computer system comprising a processor coupled with a memory, the memory having recorded thereon the computer program of claim 7.

**Patentansprüche**

1. Computerimplementiertes Verfahren zur 3D-Rep-Verarbeitung zum Durchführen einer Struktursimulation eines mechanischen Teils:

- Bereitstellen von Mittelflächen (700, 702, 704, 706, 708, 710, 712) einer 3D-Rep (Begrenzungsflächendarstellung), die einen Festkörper bildet, der das mechanische Teil darstellt, wobei jede Mittelfläche einen dünnen Abschnitt des mechanischen Teils darstellt;

- Berechnen von Zusammenführungsdrähten (740, 742, 744, 746, 748), die jeweils einer jeweiligen Zusammenführung der jeweiligen Mittelflächen auf der Grundlage von Randdrähten (720, 722, 724) der jeweiligen Mittelflächen entsprechen;

- Bestimmen einer oder mehrerer Gruppen (e1, e2, e3) jeweils von Enden von zu verbindenden Zusammenführungsdrähten (740, 744, 746) durch Identifizieren verbundener Randdrähte, die den Zusammenführungsdrähten entsprechen;

- für jede bestimmte Gruppe (e1, e2, e3) von Enden Bestimmen eines Mehrfachzusammenführungspunkts (P), der ein Verbindungspunkt der Enden ist;

- Verbinden der Zusammenführungsdrähte unter Verwendung der bestimmten Mehrzusammenführungspunkte; und

- Verbinden der Mittelflächen mit den verbundenen Zusammenführungsdrähten,

wobei für jede bestimmte Gruppe (e1, e2, e3) von Enden das Bestimmen des Mehrfachzusammenführungspunkts (P) das Bestimmen des Mehrfachzusammenführungspunkts (P) als Zwischenpunkt der Enden (e1, e2, e3) umfasst,

wobei das Verfahren ferner das Durchführen einer Simulation auf Grundlage der 3D-Rep umfasst,

wobei in der Simulation die verbundenen Mittelflächen mit 2D-Elementen vernetzt werden, und die dicken Festkörperteile der 3D-Rep mit 3D-Elementen vernetzt werden,

wobei:

- die 3D-Rep ein Fahrzeugteil darstellt und die Simulation eine Crashtest-Simulation ist, um die Ausbreitung einer Kollision und die Verformung des Teils infolge des Crashes zu simulieren; oder

- die 3D-Rep ein Fahrzeugteil oder ein Luft- und Raumfahrtteil darstellt und die Simulation eine Luftstromsimulation ist;

wobei das Verfahren ferner umfasst:

- wenn die Simulation eine Crashtest-Simulation ist, Verwenden der Ergebnisse der Simulation, um die 3D-Rep zu modifizieren, um die Verformung des Fahrzeugteils im Falle eines Crashes zu verringern; oder

- wenn die Simulation eine Luftstromsimulation ist, Verwenden der Ergebnisse der Simulation, um die 3D-Rep zu modifizieren, um die Aerodynamik des Fahrzeug- oder Luft- und Raumfahrtteils zu verbessern;

und wobei das Verfahren ferner das Verwenden der modifizierten 3D-Rep zur Herstellung des verbesserten Teils umfasst.

2. Verfahren nach Anspruch 1, wobei das Bestimmen des Mehrfachzusammenführungspunkts (P) als Zwischenpunkt der Enden (e1, e2, e3) umfasst:

- Extrapolieren jedes Zusammenführungsdrahts durch sein zu der Gruppe gehörendes Ende;

- für jeden gegebenen extrapolierten Zusammenführungsdraht Bestimmen, auf jedem anderen extrapolierten Zusammenführungsdraht, eines nächstgelegenen Punkts zu dem gegebenen extrapolierten Zusammenführungsdraht und Beibehalten eines oder mehrerer bestimmter Punkte, die einen Abstand zu allen anderen bestimmten Punkten minimieren; und
- Bestimmen des Zwischenpunkts als den Punkt unter den für jeden extrapolierten Zusammenführungsdraht beibehaltenen Punkten, der einen Abstand zu allen anderen beibehaltenen Punkten minimiert, oder, wenn es mehrere Punkte gibt, die den Abstand zu allen anderen beibehaltenen Punkten minimieren, als den Schwerpunkt dieser mehreren Punkte.

3.  Verfahren nach einem der Ansprüche 1 bis 2, wobei das Verbinden der Zusammenführungsdrähte unter Verwendung der bestimmten Mehrfachzusammenführungspunkte das Verbinden, für jede bestimmte Gruppe von Enden, jedes Endes mit einem jeweiligen Liniensegment mit dem für diese Gruppe von Enden bestimmten Mehrfachzusammenführungspunkt umfasst.

4.  Verfahren nach einem der Ansprüche 1 bis 3, wobei das Verbinden der Mittelflächen mit den verbundenen Zusammenführungsdrähten das Verbinden der Mittelflächen unter Verwendung einer Blend-Operation zwischen den verbundenen Zusammenführungsdrähten und ihren entsprechenden Randdrähten umfasst.

5.  Verfahren nach einem der Ansprüche 1 bis 4, wobei das Bestimmen der einen oder mehreren Gruppen (e1, e2, e3) jeweils von Enden von zu verbindenden Zusammenführungsdrähten (740, 744, 746) durch Identifizieren verbundener Randdrähte, die den Zusammenführungsdrähten entsprechen, umfasst:

    - für jedes gegebene Ende eines Zusammenführungsdrahts Bestimmen, für jedes Ende eines Randdrahts, das dem gegebenen Ende des Zusammenführungsdrahts entspricht, ob das Ende des Randdrahts auch dem Ende eines anderen Zusammenführungsdrahts entspricht, und wenn das Ende des Randdrahts auch dem Ende eines anderen Zusammenführungsdrahts entspricht, Zuordnen der beiden Zusammenführungsdrahtenden; und
    - Gruppieren von Enden, die paarweise zugeordnet sind, zusammen in einer selben Gruppe.

6.  Verfahren nach einem der Ansprüche 1 bis 5, wobei das Berechnen des Zusammenführungsdrahts der jeweiligen Zusammenführung der jeweiligen Mittelflächen umfasst:

- wenn die jeweiligen Mittelflächen eine L-Zusammenführung bilden, Bilden des Zusammenführungsdrahts durch Extrapolieren der jeweiligen Mittelflächen, bis eine Schnittstelle erreicht wird;
- wenn die jeweiligen Mittelflächen eine T-Zusammenführung bilden, Bilden des Zusammenführungsdrahts durch Verbinden der beiden jeweiligen Mittelflächen des unteren Teils der T-Zusammenführung mit einer Blend-Operation und Extrapolieren der jeweiligen Mittelfläche des oberen Teils der T-Zusammenführung, bis eine Schnittstelle mit dem Ergebnis der Blend-Operation erreicht wird;
- wenn die jeweiligen Mittelflächen eine Rampenzusammenführung bilden, Bilden des Zusammenführungsdrahts durch Blenden der jeweiligen Mittelflächen mit einer Blend-Operation und Versetzen eines der Randdrähte entlang des Ergebnisses des Blendens;
- wenn die jeweiligen Mittelflächen eine Rippenzusammenführung bilden, Bilden des Zusammenführungsdrahts durch Extrapolieren der oberen jeweiligen Mittelfläche, bis eine Schnittstelle mit der unteren jeweiligen Mittelfläche erreicht wird;
- wenn die jeweiligen Mittelflächen eine K-Zusammenführung oder eine Verallgemeinerung einer T-Zusammenführung mit einer beliebigen Anzahl von oberen Mittelflächen bilden, Bilden des Zusammenführungsdrahts durch Verbinden der beiden jeweiligen Mittelflächen des unteren Teils der K-Zusammenführung oder der T-Zusammenführungsverallgemeinerung mit einer Blend-Operation und Extrapolieren der jeweiligen oberen Mittelflächen der K-Zusammenführung oder T-Zusammenführungsverallgemeinerung, bis jeweils eine Schnittstelle mit dem Ergebnis der geblendeten unteren Schale erreicht ist, und gegebenenfalls Berechnen des Schwerpunktdrahts dieser Schnittstellen; und
- wenn die jeweiligen Mittelflächen eine Zusammenführung bilden, die keine Rippenzusammenführung, keine Rampenzusammenführung, keine T-Zusammenführung, keine K-Zusammenführung, keine T-Zusammenführungsverallgemeinerung oder keine L-Zusammenführung ist, Bilden des Zusammenführungsdrahts durch Berechnen eines Schwerpunktdrahts der Randdrähte der jeweiligen Mittelflächen.

7.  Computerprogramm, das Anweisungen umfasst, die, wenn sie von einem Computersystem ausgeführt werden, das Computersystem veranlassen, das Verfahren nach einem der Ansprüche 1 bis 6 durchzuführen.

8.  Computerlesbares Datenspeichermedium, auf dem das Computerprogramm nach Anspruch 7 aufgezeichnet ist.

9. Computersystem, das einen mit einem Speicher gekoppelten Prozessor umfasst, wobei im Speicher das Computerprogramm nach Anspruch 7 aufgezeichnet ist.

**Revendications**

1. Procédé, mis en œuvre par ordinateur, de traitement de représentation B-rep pour effectuer la simulation structurelle d'une pièce mécanique, comprenant le fait de :

   - fournir des surfaces médianes (700, 702, 704, 706, 708, 710, 712) d'une représentation B-rep formant un solide représentant la pièce mécanique, chaque surface médiane représentant une partie mince de la pièce mécanique ;
   - calculer des fils de jonction (740, 742, 744, 746, 748) correspondant chacun à une jonction respective des surfaces médianes respectives sur la base de fils de bordure (720, 722, 724) des surfaces médianes respectives ;
   - déterminer chacun d'un ou plusieurs groupes (e1, e2, e3) d'extrémités de fils de jonction à relier (740, 744, 746) en identifiant les fils de bordure reliés correspondant aux fils de jonction ;
   - pour chaque groupe déterminé (e1, e2, e3) d'extrémités, déterminer un point à jonctions multiples (P) qui est un point de raccordement des extrémités ;
   - relier les fils de jonction en utilisant les points à jonctions multiples déterminés ; et
   - relier les surfaces médianes aux fils de jonction reliés,

   dans lequel, pour chaque groupe déterminé (e1, e2, e3) d'extrémités, la détermination du point à jonctions multiples (P) comprend le fait de déterminer le point à jonctions multiples (P) en tant que point médian des extrémités (e1, e2, e3),
   dans lequel le procédé comprend en outre le fait d'effectuer une simulation sur la base de la représentation B-rep, dans laquelle, dans la simulation, les surfaces médianes reliées sont maillées avec des éléments 2D, et les parties solides épaisses de la représentation B-rep sont maillées avec des éléments 3D, où :

   - la représentation B-rep représente une pièce automobile et la simulation est une simulation de collision visant à simuler la propagation d'une collision et la déformation de la pièce faisant suite à la collision ; ou
   - la représentation B-rep représente une pièce automobile ou une pièce aérospatiale et la simulation est une simulation d'écoulement d'air ;

   dans lequel le procédé comprend en outre le fait de :

   - si la simulation est une simulation de collision, utiliser les résultats de la simulation pour modifier la représentation B-rep afin de réduire la déformation de la pièce automobile dans le cas d'une collision ; ou
   - si la simulation est une simulation d'écoulement d'air, utiliser les résultats de la simulation pour modifier la représentation B-rep afin d'améliorer l'aérodynamisme de la pièce automobile ou aérospatiale ; et

   dans lequel le procédé comprend en outre le fait d'utiliser la représentation B-rep modifiée afin de fabriquer la pièce améliorée.

2. Procédé selon la revendication 1, dans lequel la détermination du point à jonctions multiples (P) en tant que point médian des extrémités (e1, e2, e3) comprend le fait de :

   - extrapoler chaque fil de jonction à travers son extrémité appartenant au groupe ;
   - pour chaque fil de jonction extrapolé donné, déterminer, sur chaque autre fil de jonction extrapolé, un point le plus proche du fil de jonction extrapolé donné et conserver un ou plusieurs points déterminés qui minimisent une distance par rapport à tous les autres points déterminés ; et
   - déterminer le point médian comme étant, parmi les points conservés pour chaque fil de jonction extrapolé, le point minimisant une distance par rapport à tous les autres points conservés ou, s'il existe plusieurs points minimisant la distance par rapport à tous les autres points conservés, le barycentre desdits plusieurs points.

3. Procédé selon l'une quelconque des revendications 1 à 2, dans lequel le raccordement des fils de jonction à l'aide des points à jonctions multiples déterminés comprend, pour chaque groupe déterminé d'extrémités, le fait de relier chaque extrémité, par un segment de ligne respectif, au point à jonctions multiples déterminé pour ce groupe d'extrémités.

4. Procédé selon l'une quelconque des revendications 1 à 3, dans lequel le raccordement des surfaces médianes aux fils de jonction reliés comprend le fait de relier les surfaces médianes à l'aide d'une opération de fusion entre les fils de jonction reliés et leurs fils de bordure correspondants.

5. Procédé selon l'une quelconque des revendications 1 à 4, dans lequel la détermination de chacun du ou des groupes (e1, e2, e3) d'extrémités de fils de jonction à relier (740, 744, 746) par l'identification des fils de bordure reliés correspondant aux fils de jonction comprend le fait de :

- pour chaque extrémité donnée d'un fil de jonction, déterminer, pour chaque extrémité d'un fil de bordure qui correspond à l'extrémité donnée du fil de jonction, si l'extrémité du fil de bordure correspond également à l'extrémité d'un autre fil de jonction, et si l'extrémité du fil de bordure correspond également à l'extrémité d'un autre fil de jonction, associer les deux extrémités de fils de jonction ; et
- regrouper, dans un même groupe, les extrémités qui sont associées deux par deux.

6. Procédé selon l'une quelconque des revendications 1 à 5, dans lequel le calcul du fil de jonction de la jonction respective des surfaces médianes respectives comprend le fait de :

- si les surfaces médianes respectives forment une jonction en L, former le fil de jonction en extrapolant les surfaces médianes respectives jusqu'à ce qu'une intersection soit atteinte ;
- si les surfaces médianes respectives forment une jonction en T, former le fil de jonction en reliant les deux surfaces médianes respectives de la partie inférieure de la jonction en T par une opération de fusion et en extrapolant la surface médiane respective de la partie supérieure de la jonction en T jusqu'à atteindre une intersection avec le résultat de l'opération de fusion ;
- si les surfaces médianes respectives forment une jonction en rampe, former le fil de jonction en fusionnant les surfaces médianes respectives par une opération de fusion et en décalant l'un des fils de bordure le long du résultat de la fusion ;
- si les surfaces médianes respectives forment une jonction en nervure, former le fil de jonction en extrapolant la surface médiane supérieure respective jusqu'à atteindre une intersection avec la surface médiane inférieure respective ;
- si les surfaces médianes respectives forment une jonction en K ou toute généralisation d'une jonction en T avec un nombre arbitraire de surfaces médianes supérieures, former le fil de jonction en reliant les deux surfaces médianes respectives de la partie inférieure de la jonction en K ou de la généralisation de jonction en T par une opération de fusion, et en extrapolant les surfaces médianes supérieures respectives de la jonction en K ou de la généralisation de jonction en T jusqu'à atteindre une intersection, chacune avec le résultat de la peau inférieure fusionnée, et en calculant le fil barycentrique de ces intersections si nécessaire ; et
- si les surfaces médianes respectives forment une jonction qui n'est ni une jonction en nervure, ni une jonction en rampe, ni une jonction en T, ni une jonction en K, ni une généralisation de jonction en T, ni une jonction en L, former le fil de jonction en calculant un fil barycentrique des fils de bordure des surfaces médianes respectives.

7. Programme informatique comprenant des instructions qui, lorsqu'elles sont exécutées par un système informatique, amènent le système informatique à mettre en œuvre le procédé selon l'une quelconque des revendications 1 à 6.

8. Support de stockage de données lisible par ordinateur sur lequel est enregistré le programme informatique selon la revendication 7.

9. Système informatique comprenant un processeur couplé à une mémoire, sur laquelle mémoire est enregistré le programme informatique selon la revendication 7.

## FIG. 1

## FIG. 2

FIG. 3

FIG. 4

$$\Sigma(B) \qquad \partial B$$

FIG. 5

FIG. 6

FIG. 7

FIG. 8

FIG. 9

FIG. 10

FIG. 11

FIG. 12

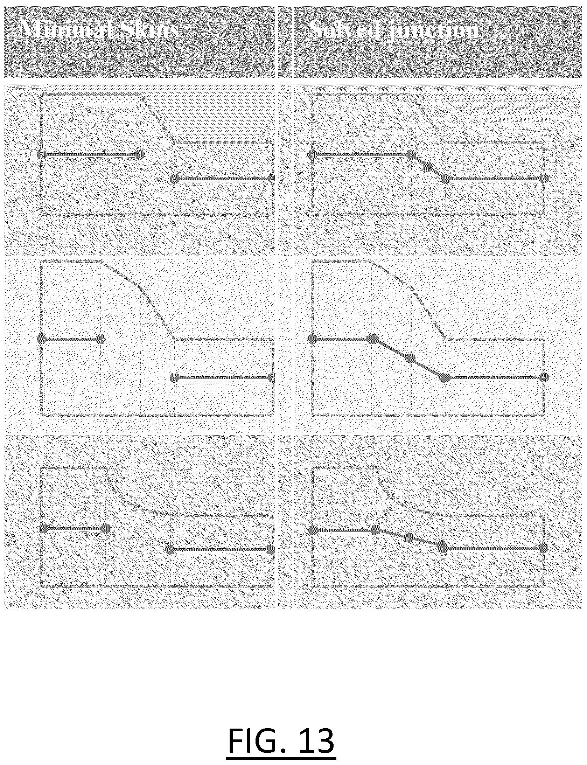

# FIG. 13

# FIG. 14

## FIG. 15

| Minimal Skins | Solved Junction |

## FIG. 16

| Minimal Skins | Solved Junction |

## FIG. 17

FIG. 18

FIG. 19

FIG. 20

FIG. 21

FIG. 22

## FIG. 23

## FIG. 24

**REFERENCES CITED IN THE DESCRIPTION**

**Patent documents cited in the description**

- EP 20305093
- EP 15305809

- EP 3327593 A
- EP 21306754, Dassault Systèmes

**Non-patent literature cited in the description**

- Midsurface abstraction from 3D solid models: general theory and applications. **M. REZAYAT**. Computer-Aided Design. Elsevier Science ltd, 1996, vol. 28, 905-915